# EUROPEAN PATENT APPLICATION

(11) **EP 4 607 216 A1**
(43) Date of publication of application: **27.08.2025**
(21) Application number: 23879455.6
(22) Date of filing: 24.08.2023
(51) Int. Cl.: G01R 31/382, G01R 31/3828, G01R 31/385, H02J 7/00

(54) **DATA INTERPOLATION SYSTEM, DATA INTERPOLATION METHOD, AND DATA INTERPOLATION PROGRAM**

(30) Priority: 19.10.2022 JP 2022167750
(71) Applicant: Panasonic Intellectual Property Management Co., Ltd., Kadoma-shi, Osaka 571-0057 (JP)
(72) Inventor: TAKEGATA Masaaki, Kadoma-shi, Osaka 571-0057 (JP)
(74) Representative: Novagraaf International SA
(86) International application number: PCT/JP2023/030484
(87) International publication number: WO 2024/084802

(57) **Abstract**

In a data interpolation system 10, a data acquirer 111 acquires battery data including at least time-series data of a current and SOC (State Of Chage). A missing part judgment unit 113 judges whether or not the battery data includes a missing section. An interpolation unit 115 interpolates battery data in the missing section based at least on battery data in a section other than the missing section. When at least one of the states before and after the missing section is a charging state, the interpolation unit 115 interpolates current data in the missing section so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

## Description

### TECHNICAL FIELD

The present disclosure relates to a data interpolation system, a data interpolation method, and a data interpolation program for interpolating missing sections of battery data.

### BACKGROUND ART

Services for storing data related to batteries installed in devices, such as EVs and PCs, on cloud servers and analyzing the data have been in widespread use. A device for collecting data collects data based on a certain sampling period. However, due to noise inside and outside the device, data may not be collected appropriately, and data may be collected at intervals longer than the specified sampling interval. In the present specification, a data section that does not meet the specified sampling interval is referred to as a missing section.

For analysis of the remaining capacity and degree of degradation of a battery, a charge amount (Ah) obtained by integrating current values is used. However, if current data is missing, current values cannot be integrated, making it difficult to analyze the battery.

Patent Literature 1 discloses three interpolation methods for missing data: "interpolation using previous and following data", "interpolation using data with high similarity in change over time", and "interpolation using correlated data".

### RELATED-ART LITERATURE

### PATENT LITERATURE

Patent Literature 1: Japanese Unexamined Patent Application Publication No. 2019-176544

### SUMMARY OF INVENTION

### TECHNICAL PROBLEM

In the abovementioned interpolation methods, prerequisites need to be met, such as the change over time being constant in the data, sufficient data having been acquired in the past, similarity with data acquired in the past being high, and the correlation being constant. In particular, when the daily operation varies and the operating state of the system changes during a data missing period, it is difficult to maintain the interpolation accuracy. Maintaining the interpolation accuracy becomes difficult also when the correlation changes due to battery degradation. For example, when the shape of the SOC (State Of Charge) - OCV (Open Circuit Voltage) curve changes due to degradation, maintaining the interpolation accuracy becomes difficult. If a missing section remains, analysis of the battery will be difficult.

The present disclosure has been made in view of such a situation, and a purpose thereof is to provide a technology for interpolating a missing section of battery data with high accuracy.

### SOLUTION TO PROBLEM

To solve the problem above, a data interpolation system according to one embodiment of the present disclosure includes: a data acquirer that acquires battery data including at least time-series data of a current and SOC; a missing part judgment unit that judges whether or not the battery data includes a missing section; and an interpolation unit that interpolates battery data in the missing section based at least on battery data in a section other than the missing section. When at least one of the states before and after the missing section is a charging state, the interpolation unit interpolates current data in the missing section so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

Optional combinations of the aforementioned constituting elements, and apparatuses, systems, methods, computer programs, and the like among which expressions in the present disclosure are transformed are also effective as embodiment of the present disclosure.

### ADVANTAGEOUS EFFECTS OF INVENTION

According to the present disclosure, a missing section of battery data can be interpolated with high accuracy.

### BRIEF DESCRIPTION OF DRAWINGS

[FIG. 1] FIG. 1 is a diagram for illustrating a data interpolation system for battery data.
[FIG. 2] FIG. 2 is a diagram that shows an example of a condition table used to judge an operating state of an electric vehicle.
[FIG. 3] FIG. 3 is a diagram that shows a first specific example of a first interpolation method.
[FIG. 4] FIG. 4 is a diagram that shows a second specific example of the first interpolation method.
[FIG. 5] FIG. 5 is a diagram that shows a third specific example of the first interpolation method.
[FIG. 6] FIG. 6 is a flowchart that shows a basic operational flow for the data interpolation system according to an embodiment.
[FIG. 7] FIG. 7 is a diagram that shows an example of interpolation processing using the first interpolation method performed by the data interpolation system according to the embodiment.
[FIG. 8] FIG. 8 is a diagram that shows a first specific example of a second interpolation method.
[FIG. 9] FIG. 9 is a diagram that shows a second specific example of the second interpolation method.
[FIG. 10] FIG. 10 is a diagram that shows a third specific example of the second interpolation method.
[FIG. 11] FIG. 11 is a diagram that shows an example of interpolation processing using the second interpolation method performed by the data interpolation system according to the embodiment.
[FIGS. 12] FIGS. 12A-12B are diagrams that show an example of SOC estimation in a missing section.

### DESCRIPTION OF EMBODIMENT

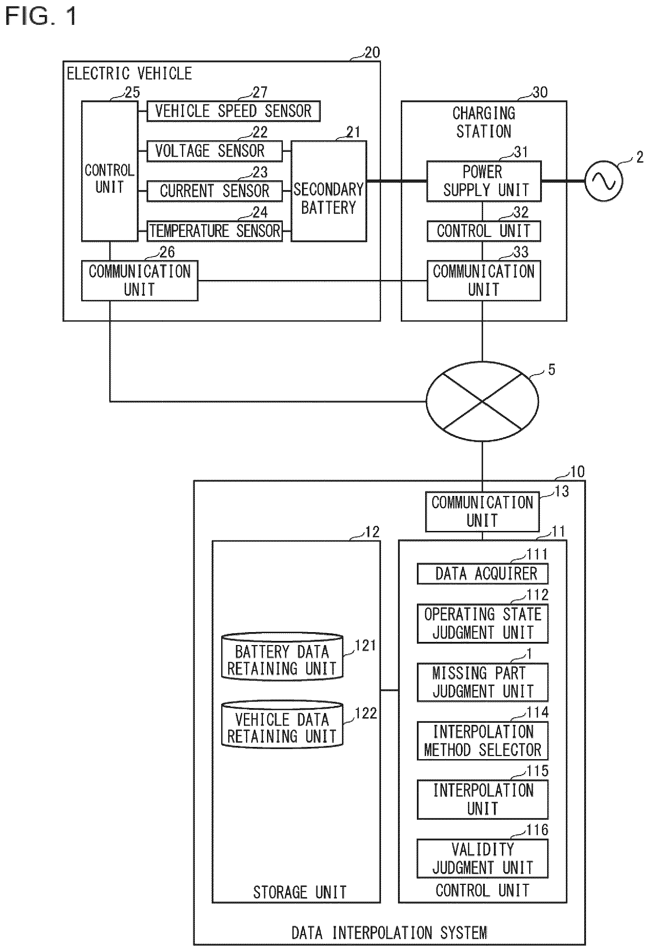

FIG. 1 is a diagram for illustrating a data interpolation system 10 for battery data. The data interpolation system 10 is a system that interpolates, when collected battery data includes a missing section, data of the missing section, as pre-processing of analysis processing for a secondary battery 21 mounted on an electric vehicle 20. For example, for a business operator that provides a service for analyzing the secondary battery 21 mounted on the electric vehicle 20, the data interpolation system 10 may be built on the business operator's own server installed in a facility of the business operator or a data center. Also, the data interpolation system 10 may be built on a cloud server used based on a cloud service. Also, the data interpolation system 10 may be built on multiple servers distributed and installed in multiple locations (such as data centers and a company's own facilities). Such multiple servers may be any of a combination of a plurality of a company's own servers, a combination of a plurality of cloud servers, and a combination of a company's own server and a cloud server.

The secondary battery 21 mounted on the electric vehicle 20 supplies electricity to a drive motor (not illustrated). The secondary battery 21 is constituted by multiple cells or multiple parallel cell blocks connected in series. Each parallel cell block is constituted by multiple cells connected in parallel.

For the cells, lithium-ion battery cells, nickel-metal hydride battery cells, lead-acid battery cells, and the like may be used. In the following, as an example, it is assumed in the present specification that lithium-ion battery cells (nominal voltage: 3.6 to 3.7 V) are used. The number of cells or parallel cell blocks connected in series is determined based on the voltage of the drive motor.

A voltage sensor 22 detects the voltage between both ends of each of cells or parallel cell blocks connected in series. A shunt resistor is connected in series with the multiple cells or multiple parallel cell blocks connected in series. Based on the voltage between both ends of the shunt resistor, a current sensor 23 detects a current flowing through the cells or parallel cell blocks connected in series. Instead of the shunt resistor, a Hall element may be used. A temperature sensor 24 detects the temperature of the multiple cells or parallel cell blocks based on the divided voltage between a thermistor and a resistor provided in at least one of the multiple cells or parallel cell blocks.

A control unit 25 is constituted by a BMU (Battery Management Unit) and an ECU (Electronic Control Unit) working in cooperation with each other. The BMU estimates the SOC by combining the OCV method and the current integration method. The OCV method is a method of estimating the SOC based on the measured OCV of a cell and the SOC-OCV curve of the cell. The current integration method is a method of estimating the SOC based on the OCV at the start of charging or discharging of a cell and the integrated value of the measured current. In the current integration method, current measurement errors accumulate as the charging or discharging time increases. Therefore, it is preferable to correct the SOC estimated by the current integration method using the SOC estimated by the OCV method.

The BMU periodically **(e.g.,** at intervals of 10 seconds) samples the voltage, current, temperature, and SOC of the multiple cells or multiple parallel cell blocks. The BMU transmits battery data including the voltage, current, temperature, and SOC of the multiple cells or multiple parallel cell blocks, to the ECU via an on-board network. As the on-board network, the CAN (Controller Area Network) or LIN (Local Interconnect Network) may be used, for example.

A vehicle speed sensor 27 generates a pulse signal proportional to the rotational speed of an axle and transmits it to the ECU. Based on the received pulse signal, the ECU calculates the vehicle speed and cumulative mileage. The ECU can acquire the gear position from the shift lever.

The electric vehicle 20 may be equipped with a GPS sensor. The GPS sensor detects the current position (latitude and longitude) and transmits it to the ECU. Based on the received current position information, the ECU can generate a driving history. The received current position information can also be used to correct the cumulative mileage.

A communication unit 26 has a function to perform communication signal processing with a communication unit 33 of a charging station 30 and a function to perform wireless signal processing for connection to a network 5. The communication unit 26 can access the network 5 using a cellular phone network (cellular network), a wireless LAN, a V2I (Vehicle-to-Infrastructure), a V2V (Vehicle-to-Vehicle), an ETC system (Electronic Toll Collection System), or DSRC (Dedicated Short Range Communications), for example.

The network 5 is a generic term for communication channels, such as the Internet, a leased line, and a VPN (Virtual Private Network), and the communication medium or protocol thereof is not specified. As the communication medium, for example, a cellular phone network, a wireless LAN, a wired LAN, an optical fiber network, an ADSL network, a CATV network, or the like may be used. As the communication protocol, for example, TCP (Transmission Control Protocol)/IP (Internet Protocol), UDP (User Datagram Protocol)/IP, Ethernet (registered trademark), or the like may be used.

The ECU may transmit the sampled battery data and vehicle data (e.g., vehicle speed, cumulative mileage, and gear position) to the data interpolation system 10 each time or may store the data in an internal memory and collectively transmit the battery data and vehicle data stored in the memory to the data interpolation system 10 at predetermined timing. When the electric vehicle 20 and the charging station 30 are connected by a charging cable, the ECU may transmit the battery data and vehicle data stored in the memory to the data interpolation system 10 via the charging station 30.

By connecting the electric vehicle 20 to the charging station 30 with a charging cable, the secondary battery 21 in the electric vehicle 20 can be charged externally. The charging station 30 is connected to a commercial power system 2 and charges the secondary battery 21.

In general, batteries are charged with AC for normal charging and with DC for fast charging. In the case of charging with AC (e.g., single-phase 100/200 V), the charging voltage or charging current is controlled by a charger (not illustrated) in the electric vehicle 20. In the case of charging with DC, the charging voltage or charging current is controlled by a power supply unit 31 of the charging station 30. The power supply unit 31 includes a rectifier circuit, a filter, and a DC/DC converter; the rectifier circuit performs full-wave rectification of AC electricity supplied from the commercial power system 2 and smooths it with the filter to generate DC electricity. The DC/DC converter controls the voltage or current of the generated DC electricity.

As the fast charging standard, CHAdeMO (registered trademark), ChaoJi, GB/T, or Combo (Combined Charging System) can be used, for example. In CHAdeMO, ChaoJi, and GB/T, CAN is employed as the communication scheme. In Combo, PLC (Power Line Communication) is employed as the communication scheme.

In a charging cable that employs the CAN system, communication lines are also included in addition to power lines. When the electric vehicle 20 and the charging station 30 are connected by this charging cable, the control unit 25 of the electric vehicle 20 establishes a communication channel with a control unit 32 of the charging station 30. Meanwhile, in a charging cable employing the PLC system, communication signals are superimposed on the power lines and transmitted.

The communication unit 33 of the charging station 30 has a function to perform communication signal processing with the communication unit 26 of the electric vehicle 20 and a function to perform signal processing for connection to the network 5. The communication unit 33 can access the network 5 using, for example, a wired LAN, a wireless LAN, or a cellular phone network.

The data interpolation system 10 includes a control unit 11, a storage unit 12, and a communication unit 13. The communication unit 13 is a communication interface (e.g., NIC: Network Interface Card) for connecting to the network 5 by wired or wireless means.

The control unit 11 includes a data acquirer 111, an operating state judgment unit 112, a missing part judgment unit 113, an interpolation method selector 114, an interpolation unit 115, and a validity judgment unit 116. The functions of the control unit 11 can be implemented by cooperation between hardware resources and software resources or only by hardware resources. As the hardware resources, CPUs, ROMs, RAMs, GPUs (Graphics Processing Units), ASICs (Application Specific Integrated Circuits), FPGAs (Field Programmable Gate Arrays), and other LSIs can be used. As the software resources, programs, such as operating systems and application programs, can be employed.

The storage unit 12 includes a non-volatile recording medium, such as an HDD or SSD, and stores various data. The storage unit 12 includes a battery data retaining unit 121 and a vehicle data retaining unit 122.

The data acquirer 111 acquires battery data and vehicle data from the electric vehicle 20 or the charging station 30, stores the acquired battery data in the battery data retaining unit 121, and stores the acquired vehicle data in the vehicle data retaining unit 122. Hereinafter, in the present embodiment, it is assumed that the vehicle data related to the operation of the electric vehicle 20 includes time-series data of the vehicle speed and cumulative mileage. It is also assumed that the battery data of the secondary battery 21 includes time-series data of the voltage, current, temperature, and SOC.

The operating state judgment unit 112 judges the operating state of the secondary battery 21 and the operating state of the electric vehicle 20 at each sampling time based on the battery data and the vehicle data. The operating state of the vehicle data includes at least a working state and a stop state. Hereinafter, in the present embodiment, the operating state of the vehicle data is classified into five states: "powered driving", "regenerative driving", "stopping (IG ON)", "resting (IG OFF)", and "stopping and charged". The "stopping and charged" means a state where a vehicle is connected to the charging station 30 and charged. The operating state of the secondary battery 21 includes at least a "charging state", a "discharging state", and a "resting state". Hereinafter, in the present embodiment, the operating state of the secondary battery 21 is classified into these three states. In the following, a state where the current is positive is regarded as a discharging state, a state where the current is negative is regarded as a charging state, and a state where the current is zero is regarded as a resting state. If the data cannot be acquired correctly, the data value will be an invalid value, such as a blank or "FFFF" in hexadecimal; all such invalid values will be expressed as NaN.

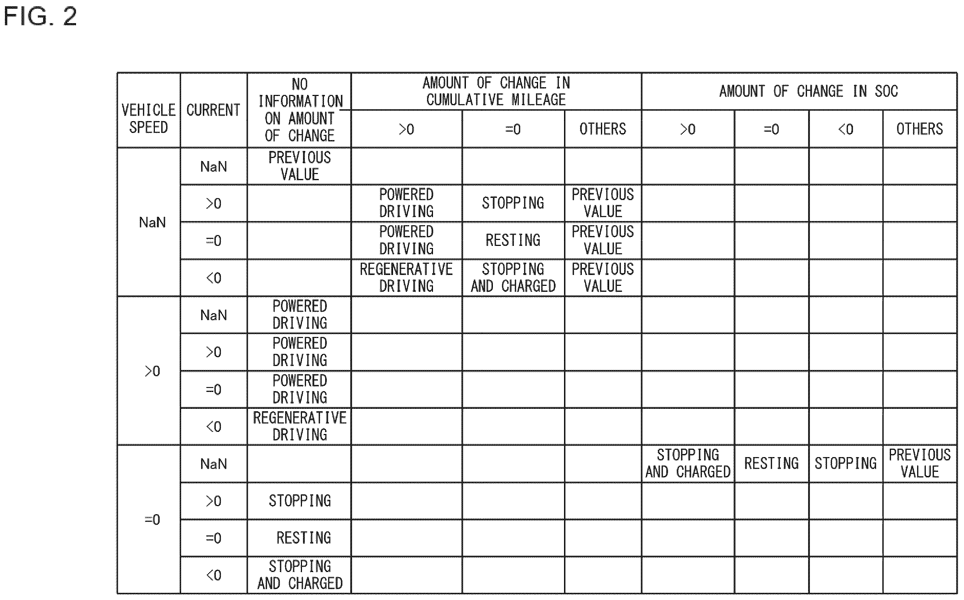

FIG. 2 shows an example of a condition table used to judge the operating state of the electric vehicle 20. When the vehicle speed is a positive value and the current is 0, a positive value, or NaN, the operating state judgment unit 112 judges that the operating state of the electric vehicle 20 is powered driving. When the vehicle speed is a positive value and the current is a negative value, the operating state judgment unit 112 judges that the operating state of the electric vehicle 20 is regenerative driving. When the vehicle speed is 0 and the current is a positive value, the operating state judgment unit 112 judges that the operating state of the electric vehicle 20 is stopping. When the vehicle speed is 0 and the current is **0,** the operating state judgment unit 112 judges that the operating state of the electric vehicle 20 is resting. When the vehicle speed is 0 and the current is a negative value, the operating state judgment unit 112 judges that the operating state of the electric vehicle 20 is stopping and charged.

When the vehicle speed is NaN, the current is a positive value or 0, and there is a positive change in the cumulative mileage, the operating state judgment unit 112 judges that the operating state of the electric vehicle 20 is powered driving. When the vehicle speed is NaN, the current is a negative value, and there is a positive change in the cumulative mileage, the operating state judgment unit 112 judges that the operating state of the electric vehicle 20 is regenerative driving. When the vehicle speed is NaN, the current is a positive value, and there is no change in the cumulative mileage, the operating state judgment unit 112 judges that the operating state of the electric vehicle 20 is stopping. When the vehicle speed is NaN, the current is 0, and there is no change in the cumulative mileage, the operating state judgment unit 112 judges that the operating state of the electric vehicle 20 is resting. When the vehicle speed is NaN, the current is a negative value, and there is no change in the cumulative mileage, the operating state judgment unit 112 judges that the operating state of the electric vehicle 20 is stopping and charged.

When the vehicle speed is 0, the current is NaN, and there is a positive change in the SOC, the operating state judgment unit 112 judges that the operating state of the electric vehicle 20 is stopping and charged. When the vehicle speed is 0, the current is NaN, and there is no change in the SOC, the operating state judgment unit 112 judges that the operating state of the electric vehicle 20 is resting. When the vehicle speed is 0, the current is NaN, and there is a negative change in the SOC, the operating state judgment unit 112 judges that the operating state of the electric vehicle 20 is stopping. When both the current and the vehicle speed are NaN or when the amount of change in the cumulative mileage or the amount of change in the SOC is an abnormal value (e.g., a negative value), the operating state of the electric vehicle 20 is set to the previous value. If sufficient data necessary for the state judgment cannot be obtained (specifically, when there is no previous value, such as the case of initial data), NaN will be set to remain (no state).

The description now returns to FIG. 1. The missing part judgment unit 113 judges whether or not the battery data includes a missing section. The missing part judgment unit 113 judges, when the amount of change in consecutive data (e.g., the time stamp, cumulative mileage, SOC, temperature, or the like) exceeds a predetermined threshold, that it is a missing section that does not meet a specified sampling interval.

The interpolation method selector 114 selects an interpolation method for the battery data in a missing section based on the operating state of the electric vehicle 20 and the operating state of the secondary battery 21. The interpolation unit 115 uses the selected interpolation method to interpolate the battery data in the missing section based at least on the battery data in a section other than the missing section. The interpolation unit 115 may interpolate the battery data in the missing section based on, for example, the battery data and the vehicle data in a section other than the missing section.

The interpolation method selector 114 selects an interpolation method based on the combination of state changes of the electric vehicle 20 and the secondary battery 21 before and after the missing section. First, a first interpolation method for current data will be described.

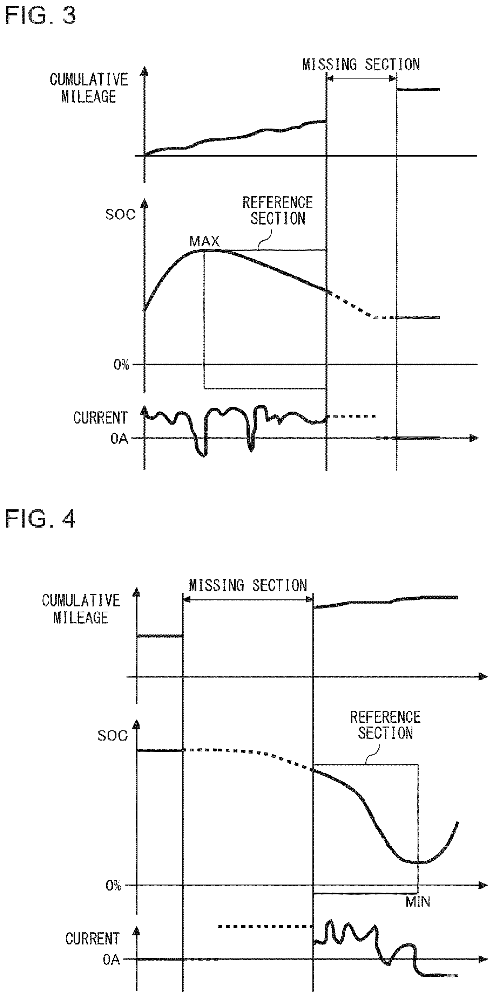

FIG. 3 is a diagram that shows a first specific example of the first interpolation method. When the cumulative mileage at the time immediately after the end of the missing section is greater than the cumulative mileage at the time immediately before the start of the missing section by a predetermined threshold **(e.g.,** 3 km) or more, the interpolation method selector 114 judges that the missing section includes a discharging state. The interpolation method selector 114 checks the operating state of the secondary battery 21 before and after the missing section. In the example shown in FIG. **3****,** the operating state of the secondary battery 21 before the missing section is a discharging state, and the operating state of the secondary battery 21 after the missing section is a resting state. In this case, the interpolation method selector 114 selects a first interpolation algorithm as described below.

The interpolation unit 115 identifies the time when the SOC reaches its maximum value in the discharge period before the missing section, within the range of a predetermined period (e.g., 6 hours) in the past direction from the start time of the missing section. The interpolation unit 115 sets the range from the time when the SOC reaches its maximum value to the start time of the missing section as a discharge reference section.

The interpolation unit 115 calculates the decrease in SOC in the discharge reference section. The interpolation unit 115 also calculates the decrease in SOC per unit time (e.g., 10 seconds) (time slope of the SOC) based on the decrease in SOC in the discharge reference section and the time of the discharge reference section. The interpolation unit 115 also calculates the increase in cumulative mileage per unit time (slope of the cumulative mileage) based on the increase in cumulative mileage in the discharge reference section and the time of the discharge reference section. The interpolation unit 115 also calculates the decrease in SOC per unit distance (e.g., 1 km) (distance slope of the SOC) based on the time slope of the SOC and the slope of the cumulative mileage in the discharge reference section.

The interpolation unit 115 calculates the discharge end time in the missing section based on the cumulative mileage at the time immediately before the start of the missing section, the distance slope of the SOC, and the cumulative mileage at the time immediately after the end of the missing section. The interpolation unit 115 also calculates the SOC at the discharge end time in the missing section based on the time when the SOC reaches its maximum value in the discharge reference section, the discharge end time in the missing section, the maximum value of the SOC, and the time slope of the SOC. The interpolation unit 115 also calculates the SOC at the start time of the missing section based on the SOC at the discharge end time in the missing section, the time from the start time of the missing section to the discharge end time in the missing section, and the time slope of the SOC.

The interpolation unit 115 calculates an estimate of the discharging current by dividing the discharge amount corresponding to the difference between the SOC at the start time of the missing section and the SOC at the discharge end time in the missing section by the time from the start time of the missing section to the discharge end time in the missing section.

The interpolation unit 115 interpolates the estimate of the discharging current (dotted line) as battery data for each time from the start time of the missing section to the discharge end time in the missing section. The interpolation unit 115 also interpolates 0 (dotted line) as battery data for each time from the discharge end time in the missing section to the end time of the missing section. The interpolation unit 115 may interpolate the cumulative mileage from the start time of the missing section to the discharge end time in the missing section, based on the slope of the cumulative mileage in the discharge reference section.

FIG. 4 is a diagram that shows a second specific example of the first interpolation method. The interpolation method selector 114 checks the operating state of the secondary battery 21 before and after the missing section. In the example shown in FIG. 4, the operating state of the secondary battery 21 before the missing section is a resting state, and the operating state of the secondary battery 21 after the missing section is a discharging state. In this case, the interpolation method selector 114 selects a second interpolation algorithm as described below.

The interpolation unit 115 identifies the time when the SOC reaches its minimum value in the discharge period after the missing section, within the range of a predetermined period (e.g., 6 hours) in the future direction from the end time of the missing section. The interpolation unit 115 sets the range from the time when the SOC reaches its minimum value to the end time of the missing section as the discharge reference section.

The interpolation unit 115 calculates the decrease in SOC in the discharge reference section. The interpolation unit 115 also calculates the time slope of the SOC based on the decrease in SOC in the discharge reference section and the time of the discharge reference section. The interpolation unit 115 also calculates the slope of the cumulative mileage based on the increase in cumulative mileage in the discharge reference section and the time of the discharge reference section. The interpolation unit 115 also calculates the distance slope of the SOC based on the time slope of the SOC and the slope of the cumulative mileage in the discharge reference section.

The interpolation unit 115 calculates the discharge start time in the missing section based on the cumulative mileage at the time immediately after the end of the missing section, the distance slope of the SOC, and the cumulative mileage at the time immediately before the start of the missing section. The interpolation unit 115 also calculates the SOC at the discharge start time in the missing section based on the time when the SOC reaches its minimum value in the discharge reference section, the discharge start time in the missing section, the minimum value of the SOC, and the time slope of the SOC. The interpolation unit 115 also calculates the SOC at the end time of the missing section based on the SOC at the discharge start time in the missing section, the time from the discharge start time in the missing section to the end time of the missing section, and the time slope of the SOC.

The interpolation unit 115 calculates an estimate of the discharging current by dividing the discharge amount corresponding to the difference between the SOC at the discharge start time in the missing section and the SOC at the end time of the missing section, by the time from the discharge start time in the missing section to the end time of the missing section. The interpolation unit 115 may calculate an estimate of the discharging current in a simplified way by dividing the discharge amount corresponding to the difference between the SOC at the time immediately before the start of the missing section and the SOC at the time immediately after the end of the missing section included in the battery data, by the time from the discharge start time in the missing section to the end time of the missing section.

The interpolation unit 115 interpolates the estimate of the discharging current (dotted line) as battery data for each time from the discharge start time in the missing section to the end time of the missing section. The interpolation unit 115 interpolates 0 (dotted line) as battery data for each time from the start time of the missing section to the discharge start time in the missing section. The interpolation unit 115 may interpolate the cumulative mileage from the discharge start time in the missing section to the end time of the missing section, based on the slope of the cumulative mileage in the discharge reference section.

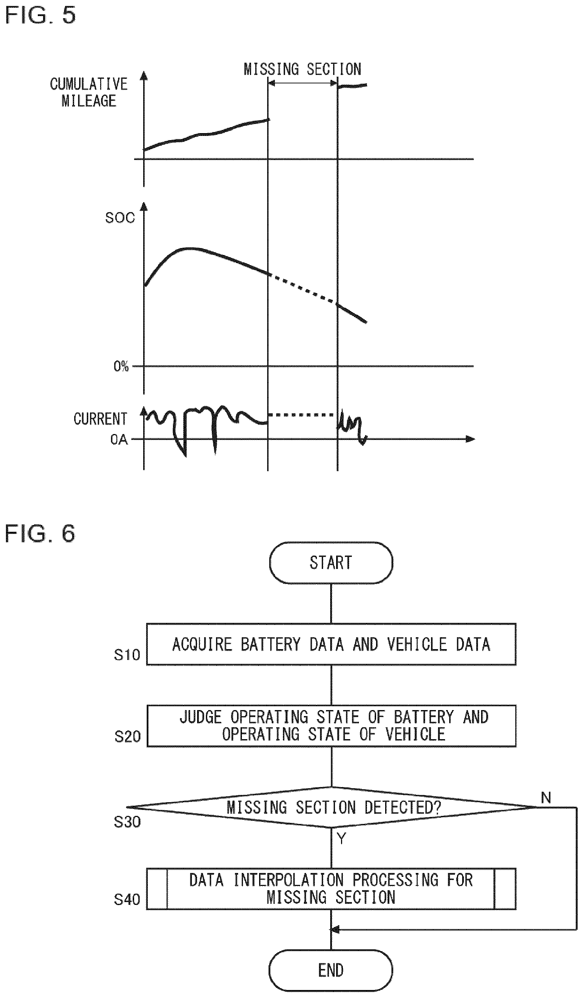

FIG. 5 is a diagram that shows a third specific example of the first interpolation method. The interpolation method selector 114 checks the operating state of the secondary battery 21 before and after the missing section. In the example shown in FIG. 5, the operating state of the secondary battery 21 before the missing section is a discharging state, and the operating state of the secondary battery 21 after the missing section is also a discharging state. In this case, the interpolation method selector 114 selects a third interpolation algorithm as described below.

The interpolation unit 115 calculates an estimate of the discharging current by dividing the discharge amount corresponding to the difference between the SOC at the time immediately before the start of the missing section and the SOC at the time immediately after the end of the missing section by the time of the missing section. The interpolation unit 115 interpolates the estimate of the discharging current (dotted line) as battery data for each time from the start time of the missing section to the end time of the missing section. The interpolation unit 115 may calculate an estimate of the discharging current in a simplified way by dividing the discharge amount corresponding to the difference between the SOC at the time immediately before the start of the missing section and the SOC at the time immediately after the end of the missing section included in the battery data, by the time from the start time of the missing section to the discharge end time in the missing section. Also, the discharging current may be estimated based on an average current value in the discharge reference section or may be estimated from past driving data using machine learning or the like.

The interpolation method selector 114 may select the first interpolation algorithm instead of the third interpolation algorithm. When the first interpolation algorithm is applied to the third specific example, it is not necessary to calculate the discharge end time in the missing section. The interpolation unit 115 calculates the SOC at the end time of the missing section based on the time when the SOC reaches its maximum value in the discharge reference section, the end time of the missing section, the maximum value of the SOC, and the time slope of the SOC. The interpolation unit 115 also calculates the SOC at the start time of the missing section based on the SOC at the end time of the missing section, the time of the missing section, and the time slope of the SOC. The subsequent processing is the same as in the first specific example.

The interpolation method selector 114 may also select the second interpolation algorithm. When the second interpolation algorithm is applied to the third specific example, it is not necessary to calculate the discharge start time in the missing section. The interpolation unit 115 calculates the SOC at the start time of the missing section based on the time when the SOC reaches its minimum value in the discharge reference section, the start time of the missing section, the minimum value of the SOC, and the time slope of the SOC. The interpolation unit 115 also calculates the SOC at the end time of the missing section based on the SOC at the start time of the missing section, the time of the missing section, and the time slope of the SOC. The subsequent processing is the same as in the second specific example.

FIG. 6 is a flowchart that shows a basic operational flow for the data interpolation system 10 according to the embodiment. The data acquirer 111 acquires battery data and vehicle data from the electric vehicle 20 or the charging station 30 (S10). Based on the battery data and the vehicle data, the operating state judgment unit 112 judges the operating state of the secondary battery 21 and the operating state of the electric vehicle 20 at each sampling time (S20). The missing part judgment unit 113 judges whether or not current data included in the battery data includes a missing section (S30). When the current data includes a missing section (Y at S30), the interpolation method selector 114 and the interpolation unit 115 perform data interpolation processing for the missing section (S40). When the current data does not include a missing section (N at S30), the interpolation processing in step S40 is skipped.

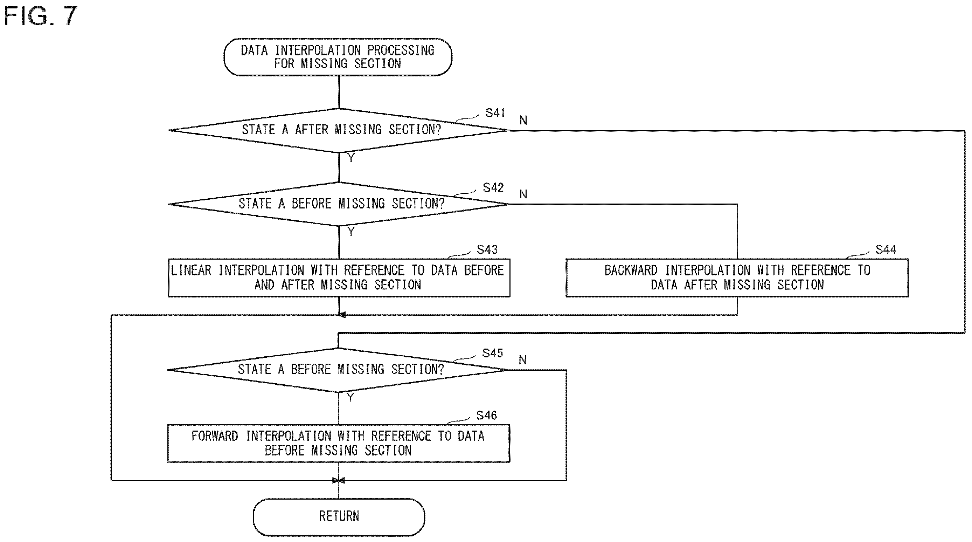

FIG. 7 shows an example of interpolation processing using the first interpolation method performed by the data interpolation system 10 according to the embodiment. In the flowchart of the subroutine shown in FIG. 7, it is assumed that the operating state of the electric vehicle 20 is not a resting state. The interpolation method selector 114 judges whether or not the state of the secondary battery 21 after the missing section is a state A (S41). When the state of the secondary battery 21 after the missing section is the state A (Y at S41), the interpolation method selector 114 judges whether or not the state of the secondary battery 21 before the missing section is the state A (S42).

When each of the state of the secondary battery 21 before the missing section and the state of the secondary battery 21 after the missing section is the state A (Y at S42), the interpolation method selector 114 selects a method for interpolation using the battery data before and after the missing section. When the state A is a discharging state, the interpolation unit 115 refers to the battery data before and after the missing section and linearly interpolates the battery data in the missing section using the battery data before and after the missing section so that continuity with the discharging states before and after the missing section is maintained (S43). When the state A is a charging state, the interpolation unit 115 refers to the battery data before and after the missing section and linearly interpolates the battery data in the missing section using the battery data before and after the missing section so that continuity with the charging states before and after the missing section is maintained (S43).

When the state of the secondary battery 21 before the missing section is not the state A and when the state of the secondary battery 21 after the missing section is the state A (N at S42), the interpolation method selector 114 selects a method for interpolation using the battery data after the missing section. When the state A is a discharging state and when there is a change from a resting state to a discharging state between before and after the missing section, the interpolation unit 115 refers to the battery data after the missing section and interpolates the battery data in the missing section using the battery data after the missing section so that continuity with the discharging state immediately after the missing section is maintained (S44). When the state A is a charging state and when there is a change from a resting state to a charging state between before and after the missing section, the interpolation unit 115 refers to the battery data after the missing section and interpolates the battery data in the missing section using the battery data after the missing section so that continuity with the charging state immediately after the missing section is maintained (S44).

When the state of the secondary battery 21 after the missing section is not the state A (N at S41), the interpolation method selector 114 judges whether or not the state of the secondary battery 21 before the missing section is the state A (S45). When the state of the secondary battery 21 before the missing section is the state A and when the state of the secondary battery 21 after the missing section is not the state A (Y at S45), the interpolation method selector 114 selects a method for interpolation using the battery data before the missing section. When the state A is a discharging state and when there is a change from a discharging state to a resting state between before and after the missing section, the interpolation unit 115 refers to the battery data before the missing section and interpolates the battery data in the missing section using the battery data before the missing section so that continuity with the discharging state immediately before the missing section is maintained (S46). When the state A is a charging state and when there is a change from a charging state to a resting state between before and after the missing section, the interpolation unit 115 refers to the battery data before the missing section and interpolates the battery data in the missing section using the battery data before the missing section so that continuity with the charging state immediately before the missing section is maintained (S46).

When each of the state of the secondary battery 21 before the missing section and the state of the secondary battery 21 after the missing section is not the state A (N at S45), the battery data in the missing section is unrelated to the discharging state or charging state, and the interpolation processing is skipped.

In step S42, when each of the state of the secondary battery 21 before the missing section and the state of the secondary battery 21 after the missing section is the state A (Y at S42), the interpolation method selector 114 may select a method for interpolation using the battery data before the missing section. In this case, the interpolation unit 115 refers to the battery data before the missing section and interpolates the battery data in the missing section using the battery data before the missing section so that continuity with the state A immediately before the missing section is maintained.

When the operating state of the electric vehicle 20 is a resting state and when at least one of the states of the secondary battery 21 before and after the missing section is a discharging state, the interpolation method selector 114 skips the interpolation processing. When there is a change from a resting state to a charging state between before and after the missing section, the interpolation unit 115 refers to the battery data after the missing section and interpolates the battery data in the missing section using the battery data after the missing section so that continuity with the charging state immediately after the missing section is maintained. When there is a change from a charging state to a resting state between before and after the missing section, the interpolation unit 115 refers to the battery data before the missing section and interpolates the battery data in the missing section using the battery data before the missing section so that continuity with the charging state immediately before the missing section is maintained.

When the states of the secondary battery 21 before and after the missing section are both charging states, the interpolation unit 115 refers to the battery data before and after the missing section and linearly interpolates the battery data in the missing section using the battery data before and after the missing section so that continuity with the charging states before and after the missing section is maintained. The interpolation unit 115 may refer to the battery data before the missing section and interpolate the battery data in the missing section using the battery data before the missing section so that continuity with the charging state immediately before the missing section is maintained.

Next, a second interpolation method will be described. The second interpolation method is an interpolation method effective when at least one of the states of the secondary battery 21 before and after the missing section is a charging state. In particular, it is an effective interpolation method when the states of the secondary battery 21 before and after the missing section are charging states.

In the second interpolation method, when at least one of the states before and after the missing section is a charging state, the interpolation unit 115 interpolates the current data in the missing section so that the discharge amount and the charge amount correspond in a charging/discharging period from SOC in the charging state immediately after the missing section to SOC corresponding to the SOC in the past direction. Alternatively, when at least one of the states before and after the missing section is a charging state, the interpolation unit 115 interpolates the current data in the missing section so that the discharge amount and the charge amount correspond in a charging/discharging period from SOC in the charging state immediately before the missing section to SOC corresponding the SOC in the future direction.

The validity judgment unit 116 judges the validity of interpolation processing based on the charge amount or charging time in the missing section based on the capacity difference between the discharge amount and the charge amount calculated from the battery data included in the charging/discharging period.

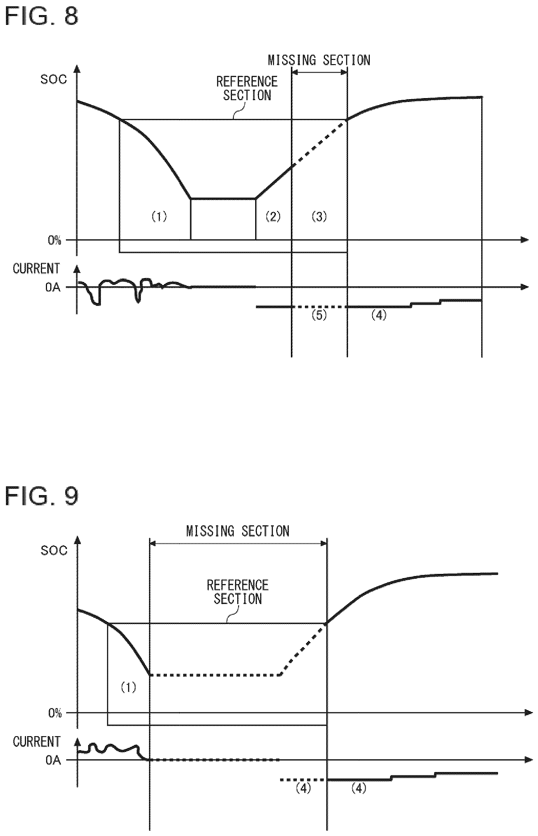

FIG. 8 is a diagram that shows a first specific example of the second interpolation method. In the second interpolation method, a charging state of the secondary battery 21 is assumed to be a charging state while the electric vehicle 20 is stopping and charged. The interpolation method selector 114 checks the operating state of the secondary battery 21 before and after the missing section. In the example shown in FIG. 8, the operating state of the secondary battery 21 before the missing section is a charging state, and the operating state of the secondary battery 21 after the missing section is also a charging state. In this case, the interpolation method selector 114 selects a fourth interpolation algorithm as described below.

The interpolation unit 115 identifies the time at which the SOC is the same as the SOC at the time immediately after the end of the missing section and that is closest from the end time of the missing section in the past direction. The interpolation unit 115 sets the range from the closest time with the same SOC to the end time of the missing section as a charge/discharge reference section. The interpolation unit 115 calculates an integrated discharge amount (1) by integrating the positive current values in the charge/discharge reference section and also calculates an integrated charge amount (2) by integrating the negative current values in the charge/discharge reference section. The interpolation unit 115 calculates a missing charge amount (3) by subtracting the integrated charge amount (2) from the integrated discharge amount (1).

The interpolation unit 115 identifies a charging current maximum value (4) (a minimum value as current data) in the range of a predetermined period (e.g., 24 hours) in the future direction from the end time of the missing section. The interpolation unit 115 may identify the charging current maximum value (4) in the charge/discharge reference section. The interpolation unit 115 may also identify the charging current maximum value (4) in both the range of the charge/discharge reference section and the range of a predetermined period in the future direction from the end time of the missing section.

The interpolation unit 115 calculates a charging current estimate (5) in the missing section by dividing the missing charge amount (3) by the time of the missing section. The interpolation unit 115 interpolates the charging current estimate (5) (dotted line) as battery data for each time from the start time to the end time of the missing section.

FIG. 9 is a diagram that shows a second specific example of the second interpolation method. The interpolation method selector 114 checks the operating state of the secondary battery 21 before and after the missing section. In the example shown in FIG. 9, the operating state of the secondary battery 21 before the missing section is a discharging state, and the operating state of the secondary battery 21 after the missing section is a charging state. In this case, the interpolation method selector 114 selects a fifth interpolation algorithm as described below.

The interpolation unit 115 identifies the time at which the SOC is the same as the SOC at the time immediately after the end of the missing section and that is closest from the end time of the missing section in the past direction. The interpolation unit 115 sets the range from the closest time with the same SOC to the end time of the missing section as the charge/discharge reference section. The interpolation unit 115 calculates the integrated discharge amount (1) by integrating the positive current values in the charge/discharge reference section. In the second specific example, the integrated charge amount (2) in the charge/discharge reference section is 0.

The interpolation unit 115 identifies the charging current maximum value (4) (a minimum value as current data) in the range of a predetermined period (e.g., 24 hours) in the future direction from the end time of the missing section. The interpolation unit 115 may identify the charging current maximum value (4) in the charge/discharge reference section. The interpolation unit 115 may also identify the charging current maximum value (4) in both the range of the charge/discharge reference section and the range of a predetermined period in the future direction from the end time of the missing section.

The interpolation unit 115 calculates the charging time in the missing section by dividing the missing charge amount (= integrated discharge amount (1) - 0) by the charging current maximum value (4). The interpolation unit 115 sets, as the charge start time in the missing section, the time shifted backward from the end time of the missing section in the past direction by the charging time in the missing section. The interpolation unit 115 interpolates the charging current maximum value (4) (dotted line) as battery data for each time from the charge start time in the missing section to the end time of the missing section. The interpolation unit 115 interpolates 0 (dotted line) as battery data for each time from the start time of the missing section to the charge start time in the missing section.

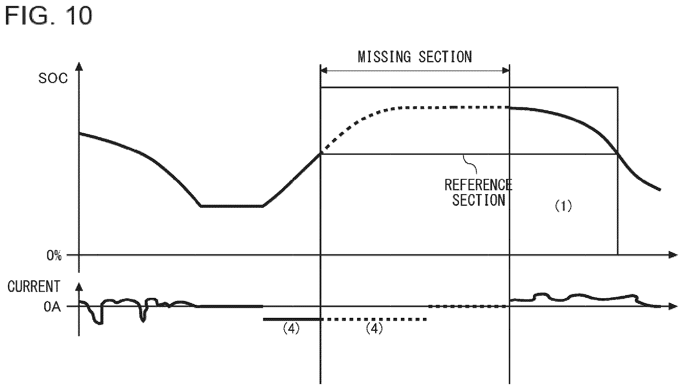

FIG. 10 is a diagram that shows a third specific example of the second interpolation method. The interpolation method selector 114 checks the operating state of the secondary battery 21 before and after the missing section. In the example shown in FIG. 10, the operating state of the secondary battery 21 before the missing section is a charging state, and the operating state of the secondary battery 21 after the missing section is a discharging state. In this case, the interpolation method selector 114 selects a sixth interpolation algorithm as described below.

The interpolation unit 115 identifies the time at which the SOC is the same as the SOC at the time immediately before the start of the missing section and that is closest from the start time of the missing section in the future direction. The interpolation unit 115 sets the range from the closest time with the same SOC to the start time of the missing section as the charge/discharge reference section. The interpolation unit 115 calculates the integrated discharge amount (1) by integrating the positive current values in the charge/discharge reference section. In the third specific example, the integrated charge amount (2) in the charge/discharge reference section is 0.

The interpolation unit 115 identifies the charging current maximum value (4) (a minimum value as current data) in the range of a predetermined period (e.g., 24 hours) in the past direction from the start time of the missing section. The interpolation unit 115 may identify the charging current maximum value (4) in the charge/discharge reference section. The interpolation unit 115 may also identify the charging current maximum value (4) in both the range of the charge/discharge reference section and the range of a predetermined period in the past direction from the start time of the missing section.

The interpolation unit 115 calculates the charging time in the missing section by dividing the missing charge amount (= integrated discharge amount (1) - 0) by the charging current maximum value (4). The interpolation unit 115 sets, as the charge end time in the missing section, the time shifted forward from the start time of the missing section in the future direction by the charging time in the missing section. The interpolation unit 115 interpolates the charging current maximum value (4) (dotted line) as battery data for each time from the start time of the missing section to the charge end time in the missing section. The interpolation unit 115 also interpolates 0 (dotted line) as battery data for each time from the charge end time in the missing section to the end time of the missing section.

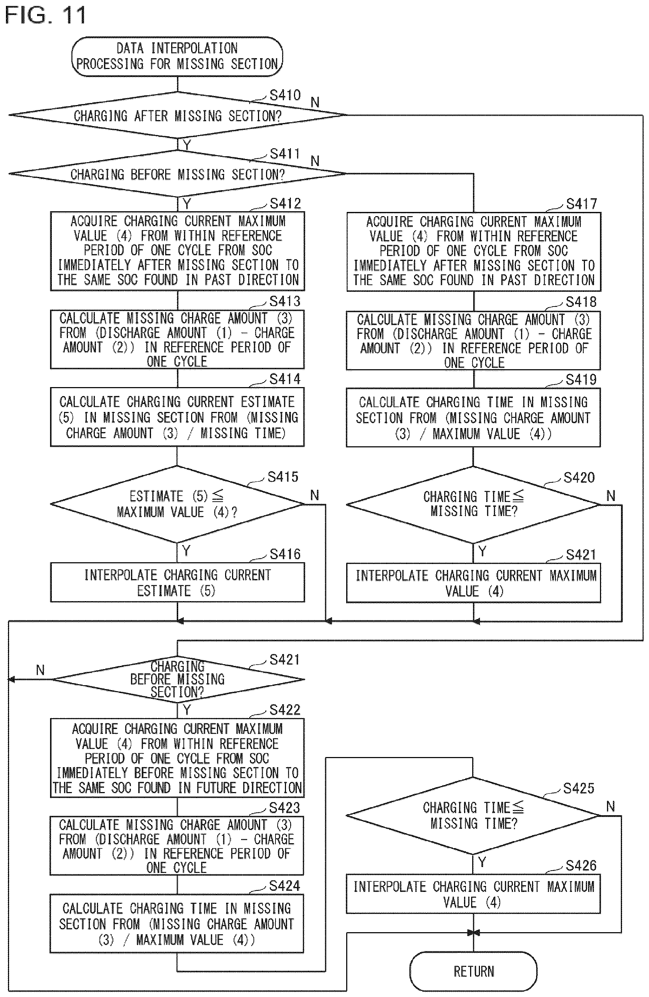

FIG. 11 shows an example of interpolation processing using the second interpolation method performed by the data interpolation system 10 according to the embodiment. The interpolation method selector 114 judges whether or not the state of the secondary battery 21 after the missing section is a charging state (S410). When the state of the secondary battery 21 after the missing section is a charging state (Y at S410), the interpolation method selector 114 judges whether or not the state of the secondary battery 21 before the missing section is a charging state (S411).

When each of the state of the secondary battery 21 before the missing section and the state of the secondary battery 21 after the missing section is a charging state (Y at S411), the interpolation unit 115 sets the range from the SOC at the time immediately after the end of the missing section to the same SOC found in the past direction, as a charge/discharge reference period of one cycle. The interpolation unit 115 acquires the charging current maximum value (4) from within the charge/discharge reference period of one cycle (S412). In the flowchart of FIG. 11, the charging current maximum value (4) is an absolute value.

The interpolation unit 115 calculates the missing charge amount (3) by subtracting the integrated charge amount (2) from the integrated discharge amount (1) in the charge/discharge reference section (S413). The interpolation unit 115 also calculates the charging current estimate (5) by dividing the missing charge amount (3) by the time of the missing section (S414). In the flowchart of FIG. 11, the charging current estimate (5) is an absolute value.

The validity judgment unit 116 compares the charging current estimate (5) with the charging current maximum value (4) (S415). When the charging current estimate (5) is less than or equal to the charging current maximum value (4) (Y at S415), the interpolation unit 115 interpolates the charging current estimate (5) into the missing section (S416). When the charging current estimate (5) exceeds the charging current maximum value (4) (N at S415), the validity judgment unit 116 judges that the interpolation current value is inappropriate and skips the interpolation processing.

When the state of the secondary battery 21 before the missing section is a discharging state or resting state and when the state of the secondary battery 21 after the missing section is a charging state (N at S411), the interpolation unit 115 sets the range from the SOC at the time immediately after the end of the missing section to the same SOC found in the past direction, as the charge/discharge reference period of one cycle. The interpolation unit 115 acquires the charging current maximum value (4) from within the charge/discharge reference period of one cycle (S417).

The interpolation unit 115 calculates the missing charge amount (3) by subtracting the integrated charge amount (2) from the integrated discharge amount (1) in the charge/discharge reference section (S418). The interpolation unit 115 also calculates the charging time in the missing section by dividing the missing charge amount (3) by the charging current maximum value (4) (S419).

The validity judgment unit 116 compares the charging time in the missing section with the time of the entire missing section (S420). When the charging time in the missing section is less than or equal to the time of the entire missing section (Y at S420), the interpolation unit 115 interpolates the charging current maximum value (4) into the charging section in the missing section (S421). When the charging time in the missing section exceeds the time of the entire missing section (N at S420), the validity judgment unit 116 judges that the charging time in the missing section is inappropriate and skips the interpolation processing.

When the state of the secondary battery 21 after the missing section is not a charging state (N at S410), the interpolation method selector 114 judges whether or not the state of the secondary battery 21 before the missing section is a charging state (S421). When the state of the secondary battery 21 before the missing section is a discharging state or resting state and when the state of the secondary battery 21 after the missing section is a charging state (Y at S421), the interpolation unit 115 sets the range from the SOC at the time immediately before the start of the missing section to the same SOC found in the future direction, as the charge/discharge reference period of one cycle. The interpolation unit 115 acquires the charging current maximum value (4) from within the charge/discharge reference period of one cycle (S422).

The interpolation unit 115 calculates the missing charge amount (3) by subtracting the integrated charge amount (2) from the integrated discharge amount (1) in the charge/discharge reference section (S423). The interpolation unit 115 calculates the charging time in the missing section by dividing the missing charge amount (3) by the charging current maximum value (4) (S424).

The validity judgment unit 116 compares the charging time in the missing section with the time of the entire missing section (S425). When the charging time in the missing section is less than or equal to the time of the entire missing section (Y at S425), the interpolation unit 115 interpolates the charging current maximum value (4) into the charging section in the missing section (S426). When the charging time in the missing section exceeds the time of the entire missing section (N at S425), the validity judgment unit 116 judges that the charging time in the missing section is inappropriate and skips the interpolation processing.

When each of the state of the secondary battery 21 before the missing section and the state of the secondary battery 21 after the missing section is not a charging state (N at S421), the battery data in the missing section is unrelated to a charging state, and the interpolation processing is skipped.

In steps S413, S418, and S423 described above, when the calculated integrated discharge amount (1) or integrated charge amount (2) in the charge/discharge reference section exceeds the rated capacity of the secondary battery 21, the validity judgment unit 116 may judge that the interpolation processing is inappropriate and skip the subsequent interpolation processing. The rated capacity of the secondary battery 21 is the current full charge capacity, and the current full charge capacity is calculated by multiplying the initial full charge capacity by SOH (State Of Health).

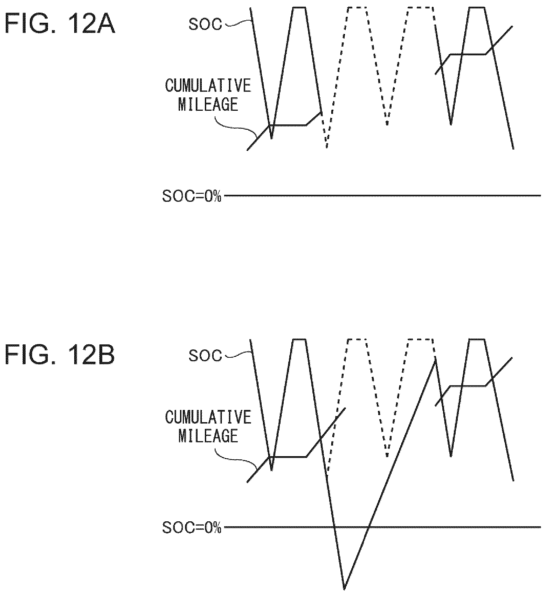

FIGS. 12A-12B are diagrams that show an example of SOC estimation in a missing section. The example shown in FIG. 12A is an example in which the missing section includes two cycles of charging and discharging. In the second interpolation method described above, the missing section is recognized as one cycle of charging and discharging. Therefore, the transition of SOC due to charging and discharging in the missing section is recognized as shown in FIG. 12B. In this case, the SOC becomes less than 0% due to the discharging in the missing section, which indicates inappropriate interpolation processing. By comparing the discharge amount or charge amount in the charge/discharge reference section with the rated capacity of the secondary battery 21, inappropriate interpolation processing can be avoided.

In steps S413, S418, and S423 described above, when the calculated integrated charge amount (2) exceeds the calculated integrated discharge amount (1) in the charge/discharge reference section, the validity judgment unit 116 may judge that the interpolation processing is inappropriate and skip the subsequent interpolation processing.

In the above description, the interpolation method selector 114 may first interpolate the current data of a discharging state in the missing section using the first interpolation method and then interpolate the current data of a charging state in the missing section using the second interpolation method.

As described above, according to the present embodiment, a missing section of battery data can be interpolated with high accuracy, which improves the usefulness of the battery data. In the first interpolation method, inappropriate interpolation can be avoided by changing the interpolation method according to the operating state of the electric vehicle 20, so that the accuracy of the interpolation data can be improved.

In the second interpolation method, since the SOC is used relatively, the effect of SOC errors caused by degradation of the secondary battery 21 and the effect of rated capacity can be eliminated. In specific, the shape of the SOC-OCV curve of the secondary battery 21 changes due to degradation. Errors caused by the effects of SOC errors and rated capacity become large in a method in which the charge amount in the missing section is calculated by calculating the difference in SOC based on the OCV measured at each of the time immediately before the start of the missing section and the time immediately after the end of the missing section and multiplying the difference in SOC by the rated capacity of the secondary battery 21.

Also, the current sensor 23 has a measurement error, and the measurement errors are accumulated in the charge amount obtained by integrating the current. The data for a longer period includes increased measurement errors. In this regard, in the second interpolation method, the measurement errors in discharging and charging can be offset by using the capacity difference between the discharge amount and the charge amount during the charge/discharge reference period. Accordingly, the measurement errors are only the errors for the missing section.

In particular, when the states of the secondary battery 21 before and after the missing section are charging states, interpolation can be performed with high accuracy by selecting the second interpolation method. Further, by judging the validity of the charging current value to be interpolated, performing interpolation processing with low accuracy can be avoided, so that the accuracy of the interpolation processing can be ensured.

The present disclosure has been described with reference to an embodiment. The embodiment is intended to be illustrative only, and it will be obvious to those skilled in the art that various modifications to a combination of constituting elements or processes in the embodiment could be developed and that such modifications also fall within the scope of the present disclosure.

The data interpolation system 10 described above may be provided in the control unit 25 of the electric vehicle 20 or the control unit 32 of the charging station 30.

In the aforementioned embodiment, a four-wheeled electric automobile is assumed as the electric vehicle 20. In this regard, an electric motorcycle (electric scooter), an electric bicycle, or an electric kick scooter may also be used. Also, the electric automobiles include not only full-standard electric automobiles but also low-speed electric automobiles, such as golf carts and land cars. Further, the device in which the secondary battery 21 is mounted is not limited to the electric vehicle 20. The device in which the secondary battery 21 is mounted includes an electric ship, a railway vehicle, an electric movable body such as a multicopter (drone), a stationary electricity storage system, and a consumer electronic device (smartphone, notebook PC, or the like). When the secondary battery 21 is mounted in a stationary electricity storage system or consumer electronic device, the operating state of the device does not include a regenerative charging state.

The embodiment may be defined by the following Items.

### Item 1

A data interpolation system (10), comprising:
a data acquirer (111) that acquires battery data including at least time-series data of a current and SOC (State Of Chage);
a missing part judgment unit (113) that judges whether or not the battery data includes a missing section; and
an interpolation unit (115) that interpolates battery data in the missing section based at least on battery data in a section other than the missing section, wherein
when at least one of the states before and after the missing section is a charging state, the interpolation unit (115) interpolates current data in the missing section so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

According to this, a missing section of battery data can be interpolated with high accuracy.

### Item 2

The data interpolation system (10) according to Item 1, further comprising a validity judgment unit (116) that judges validity of interpolation processing based on a charge amount or charging time in the missing section based on a capacity difference between a discharge amount and a charge amount calculated from battery data included in the charging/discharging period.

According to this, inappropriate interpolation can be avoided.

### Item 3

The data interpolation system (10) according to Item 2, wherein, when the discharge amount or the charge amount in the charging/discharging period exceeds the rated capacity of the battery (21), the validity judgment unit (116) judges that interpolation processing is inappropriate.

According to this, inappropriate interpolation can be avoided.

### Item 4

The data interpolation system (10) according to Item 2, wherein, when the charge amount exceeds the discharge amount in the charging/discharging period, the validity judgment unit (116) judges that interpolation processing is inappropriate.

According to this, inappropriate interpolation can be avoided.

### Item 5

The data interpolation system (10) according to Item 2, wherein, when an estimate of a charging current obtained from the capacity difference and the time of the missing section is larger than a maximum value of a charging current in a charging period before or after the missing section, the validity judgment unit (116) judges that interpolation processing is inappropriate.

According to this, inappropriate interpolation can be avoided.

### Item 6

A data interpolation method, comprising:
acquiring battery data including at least time-series data of a current and SOC (State Of Chage);
judging whether or not the battery data includes a missing section; and
interpolating battery data in the missing section based at least on battery data in a section other than the missing section, wherein
in the interpolating, when at least one of the states before and after the missing section is a charging state, current data in the missing section is interpolated so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

According to this, a missing section of battery data can be interpolated with high accuracy.

### Item 7

A data interpolation program causing a computer to implement:
acquiring battery data including at least time-series data of a current and SOC (State Of Chage);
judging whether or not the battery data includes a missing section; and
interpolating battery data in the missing section based at least on battery data in a section other than the missing section, wherein
in the interpolating, when at least one of the states before and after the missing section is a charging state, current data in the missing section is interpolated so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

According to this, a missing section of battery data can be interpolated with high accuracy.

### INDUSTRIAL APPLICABILITY

The present disclosure is applicable to battery analysis systems built on cloud servers.

### REFERENCE SIGNS LIST

2 commercial power system, 5 network, 10 data interpolation system, 11 control unit, 12 storage unit, 13 communication unit, 20 electric vehicle, 21 secondary battery, 22 voltage sensor, 23 current sensor, 24 temperature sensor, 25 control unit, 26 communication unit, 27 vehicle speed sensor, 30 charging station, 31 power supply unit, 32 control unit, 33 communication unit, 111 data acquirer, 112 operating state judgment unit, 113 missing part judgment unit, 114 interpolation method selector, 115 interpolation unit, 116 validity judgment unit, 121 battery data retaining unit, 122 vehicle data retaining unit

## Claims

1. A data interpolation system, comprising:
a data acquirer that acquires battery data including at least time-series data of a current and SOC (State Of Chage);
a missing part judgment unit that judges whether or not the battery data includes a missing section; and
an interpolation unit that interpolates battery data in the missing section based at least on battery data in a section other than the missing section, wherein
when at least one of the states before and after the missing section is a charging state, the interpolation unit interpolates current data in the missing section so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

2. The data interpolation system according to Claim 1, further comprising a validity judgment unit that judges validity of interpolation processing based on a charge amount or charging time in the missing section based on a capacity difference between a discharge amount and a charge amount calculated from battery data included in the charging/discharging period.

3. The data interpolation system according to Claim 2, wherein, when the discharge amount or the charge amount in the charging/discharging period exceeds the rated capacity of the battery, the validity judgment unit judges that interpolation processing is inappropriate.

4. The data interpolation system according to Claim 2, wherein, when the charge amount exceeds the discharge amount in the charging/discharging period, the validity judgment unit judges that interpolation processing is inappropriate.

5. The data interpolation system according to Claim 2, wherein, when an estimate of a charging current obtained from the capacity difference and the time of the missing section is larger than a maximum value of a charging current in a charging period before or after the missing section, the validity judgment unit judges that interpolation processing is inappropriate.

6. A data interpolation method, comprising:
acquiring battery data including at least time-series data of a current and SOC (State Of Chage);
judging whether or not the battery data includes a missing section; and
interpolating battery data in the missing section based at least on battery data in a section other than the missing section, wherein
in the interpolating, when at least one of the states before and after the missing section is a charging state, current data in the missing section is interpolated so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.

7. A data interpolation program causing a computer to implement:
acquiring battery data including at least time-series data of a current and SOC (State Of Chage);
judging whether or not the battery data includes a missing section; and
interpolating battery data in the missing section based at least on battery data in a section other than the missing section, wherein
in the interpolating, when at least one of the states before and after the missing section is a charging state, current data in the missing section is interpolated so that a discharge amount and a charge amount correspond in a charging/discharging period from SOC in the charging state immediately after the missing section to corresponding SOC found in the past direction or in a charging/discharging period from SOC in the charging state immediately before the missing section to corresponding SOC found in the future direction.
